# EUROPEAN PATENT SPECIFICATION

(11) **EP 2 849 172 B1**
(45) Date of publication and mention of the grant of the patent: **20.02.2019**
(21) Application number: 13184599.2
(22) Date of filing: 16.09.2013
(51) Int. Cl.: G09F 9/35, H03K 17/96

(54) **Operating device and electric appliance with such an operating device**
Betriebsvorrichtung und elektrisches Gerät mit solch einer Betriebsvorrichtung
Dispositif de commande et appareil électrique comportant un tel dispositif de commande

(43) Date of publication of application: 18.03.2015
(73) Proprietor: E.G.O. Elektro-Gerätebau GmbH, 75038 Oberderdingen (DE)
(72) Inventor: Mañan, Jose Antonio, 08110 Montcada i Reixac (ES)
(74) Representative: Patentanwälte Ruff, Wilhelm, Beier, Dauster & Partner mbB

(56) References cited:
- EP-A1- 1 542 363
- EP-A2- 0 884 626
- GB-A- 1 447 111
- US-A- 3 895 866
- US-A1- 2010 097 344

## Description

### Field of application and prior art

The invention relates to an operating device for an electric appliance as well as to an electric appliance with such an operating device.

An operating device for a coffee machine as an electric appliance is known for example from EP 2111779 A, which comprises a display panel and touch switches.

GB 1 447 111 A discloses a display apparatus for projecting an image from a film driven by driving means onto a backside of an LCD display. The projected image may then be viewed through the LCD display.

From US 3,895,866 A, another display apparatus is known using an LCD display. The picture or symbols displayed by the LCD display D can be projected with light and with a reflector onto a projection screen.

From EP 0884626 A2, a detailed LCD display is known. This LCD display may be a negative LCD display.

From US 2010/0097344 A1 an operating device is known to be implemented in a mobile hand-held device. This operating device also is provided with capacitive sensor elements as touch switches.

From EP 1 542 363 A1 an operating device for vending machines is known being provided with backlighted labels and proximity sensors as operating elements. Behind a circuit board carrying the proximity sensors, lighting means are provided for backlighting the transparent or translucent labels.

### Object and solution

The object of the invention is to provide an aforementioned operating device for an electric appliance as well such an electric appliance, with which drawbacks of the prior art can be avoided and with which it is in particular possible to provide a simple and energy efficient way to display information to a user, preferably with detailed and colored icons, and to provide a way of operating the appliance.

This object is achieved by the invention with an operating device with the features of claim 1 as well as an electric appliance with the features of claim 12. Advantageous and preferred embodiments of the invention are the subject of the further claims and will be explained in more detail in the following. Some of the technical features will be described only for the operating device or only for the electric appliance. However, independently thereof, they shall be applicable to the operating device as well as to the electric appliance in independent manner. The wording of the claims is incorporated into the description by explicit reference.

The operating device has a display or a display panel, respectively, for a user where information or icons can be displayed and the user can see them or read them off. Furthermore, the user may operate the electric appliance with operating elements provided on the display panel or on the operating device, respectively. The display panel has an LCD display covering substantially the area of the display panel, wherein preferably the LCD display makes up a major part of the display panel. The LCD display has several separate active areas, which means that they can be activated or deactivated in the manner of a conventional LCD. Preferably these areas are in a simple basic geometrical shape, for example in rectangular or square shape. These separate active areas can preferably make up most part of the LCD display.

According to the invention, behind the LCD display a transparent flat material, preferably in the form of a transparent foil, is provided and has several pictures, icons or symbols on one of its surfaces. This transparent flat material or foil forms a picture carrier for the display panel. The pictures, icons or symbols are preferably applied to only one of its surfaces, in particular to the top surface. Behind the transparent picture carrier a backlight device is provided for shining or lighting through the picture carrier and through the LCD display. This backlight device is preferably a conventional backlight device that can regularly be used for LCD displays as they do not have any own light source.

In this way, it is possible to make the display panel and especially the LCD display in a way that by activating or deactivating the several active areas the LCD display is either transparent or black and non-transparent. In the transparent state, the pictures, icons or symbols provided on the picture carrier being lit from behind by the backlight device are visible in backlighted manner, which provides for a very clear, bright and detailed view. Preferably the separate active areas of the LCD display correspond in size to the pictures, icons or symbols, for example in a way that each picture, icon or symbol has its own separate active area and can be covered by the area or be revealed.

Thus, the invention provides for an operating device with a display panel with which very detailed and high resolution pictures, icons or symbols can be used, even in any bright colour. However, there is no need to provide for an expensive and energy consuming active display such as TFT or LED-displays. High resolution pictures can be displayed with only minor effort. Furthermore, an LCD display is much less energy consuming than TFT or even LED-displays.

In preferable manner the active areas of the LCD display are arranged according to a pattern. The pattern may be provided as a pattern field with several pattern areas. The pattern areas may be of any arbitrary size or form defining the active areas. However, for an easier division of the active areas as well as of the pictures, icons or symbols on the picture carrier, they can have an average size of a regular pattern. Some of the active areas may correspond to one such pattern area. Other active areas may correspond to the size and form of a number of such pattern areas, for example two to five such pattern areas.

In even more preferable manner, the LCD display is a common LCD display with a resolution of at least fifty ora hundred pixels horizontally and vertically, for example with a resolution of 50 x 50 pixels or higher, possibly even a VGA or SVGA resolution. This provides for the option to display other information or symbols than just the ones with the pictures from the flat material or foil, for example indications of power or time for a timer functionThis corresponds to the conventional function of an LCD display, whereas the function with covering or uncovering the pictures from the flat material or foil is rather a shutter function. Even in the place where the above-mentioned active areas are to be provided the LCD display has dozens of separate pixels for one such active area. They are however combined to function as one area being activated or deactivated together. The use of standard LCD displays provides is more cost-efficient and their control can be made with standard software and hardware solutions.

In a further embodiment of the invention, the backlight device provides for a uniform and homogeneous lighting effect across its surface. This corresponds to conventional backlight devices as known to a person skilled in the art in the field of backlit LCD devices. However, as obviously a major part of the pictures, icons or symbols shall not be displayed or, respectively, only a minor part of the area of the display panel shall be used at the same time and lit from behind for this use, also the backlight device can be divided into several fields corresponding to the active areas of the LCD display or, even better, corresponding to each picture, icon or symbol of the picture carrier. In this way, only the picture, icon or symbol that is to be displayed is lit from behind, which may again safe energy. The covering of the remaining area of the picture carrier by the black and non-transparent LCD display is advantageous nonetheless, because usually such a backlight device has a light diffusing means on its surface which provides for a uniformly distributed lighting effect and does not allow for a strictly defined light field.

In an advantageous embodiment of the invention, the backlight device is provided with LED as a light source and light diffusing means above the LED. Preferably, a standard backlight device for LCD displays can be used.

According to the invention, the LCD display is a negative LCD, which means that its active areas or the LCD has a whole, respectively, are black and intransparent in an inactive state without excitation voltage. This results in the picture carrier being covered and being invisible in an inactive state of the LCD display, which obviously is very energy efficient. Only when some of the active areas are activated by an excitation voltage do they become transparent so that the pictures, icons or symbols underneath it become visible, which is improved much by the backlight device. In consequence, only energy for making those active areas transparent is needed that shall reveal the pictures, icons or symbols underneath to be visible. Furthermore, if the backlight device can be partly activated, for example corresponding to the above mentioned pattern or the pictures, icons or symbols of the picture carrier, together with an activation of an active area of the LCD display, this part of the backlight device can be switched on. This allows for a further reduction in energy consumption even in the display state.

In a further embodiment of the invention, the picture carrier can cover only a part of the LCD display, which may be a major part of it, for example 60% or 80%. The rest of the LCD display is provided with conventional LCD symbols being backlit by the backlight device. This allows for a more flexible display of information which cannot be provided for by pictures, icons or symbols in a fixed manner. For example different power levels or a timer setting may advantageously be displayed by such LCD symbols, possibly in the form of so-called seven-segment displays. This can be realized with a positive LCD as well as with a negative LCD as mentioned before.

In an even further embodiment of the invention, capacitive sensor elements for touch switches as operating elements of the operating device may be provided on the display panel. Such is basically known, for example from the above mentioned EP 2111779 A. Such capacitive sensor elements are preferably made from a transparent and electrically conductive material, for example ITO. They can be printed or affixed, respectively, to the LCD display. This can be done directly onto the LCD display, for example on the upper side of it or on its upper protective glass sheet, respectively. Furthermore, it is possible to provide a further protective cover above the LCD display, for example made from glass or acrylic resin and which may also be a part of the electric appliance. In this case, the capacitive sensor elements for the touch switches can also be provided on the underside of such a protective cover. They can be directly printed on the underside or otherwise be applied to it from the above mentioned electrically conductive and transparent material. Alternatively, the capacitive sensor elements may be provided on a foil carrier or the like, which is then applied to the underside of the cover, alternatively on the upper side of the LCD, for example with an adhesive. Such a foil carrier can preferably also be provided with contact pads and contact tracks to the sensor elements, preferably made from the same material, which allows for an electrical connection to a control, preferably the control of the operating device.

Capacitive sensor elements or touch sensors could be in the size of one of the active areas or pictures from the flat material or foil. Preferably they are provided according to a matrix in substantially equal size and distribution. That provides for the possibility to have them everywhere over the LCD display and in many possible configurations. This also provides for the option to employ conventional and often-used matrix touch switches, which is more cost-efficient, and their control can be made with standard software and hardware solutions.

The electric appliance in which such an operating device may be incorporated can basically be any electric appliance. The operating device according to the invention is then preferably arranged in a manner corresponding to conventional operating devices.

In preferred manner, the electric appliance is of a kind that can have a display panel with several different options being suitable for display by pictures, icons or symbols. Preferred xamples for such an electric appliance are a vending machine or a coffee machine, alternatively a cooking appliance such as an oven, a steamer or a cook top operated by electricity or gas. Further preferable examples are washing machines, dishwashers and refrigerators.

These features and further features arise not only from the claims but from the description and the drawings, wherein the individual features can be realized in each case on their own or in sub-combinations thereof in an embodiment of the invention and in other fields and can represent advantageous embodiments protectable per se, for which protection is hereby claimed. The division of the application into individual sections as well as cross headings does not limit the general validity of the statements made therein.

### Brief description of the drawings

Exemplary embodiments of the invention are schematically shown in the drawings and will be explained in more detail in the following. The drawings show in:
- Fig. 1: an exploded view on the components of an operating device according to the invention with an LCD display, a picture carrier and a backlight device,
- Fig. 2: the operating device of fig. 1 in more packed manner,
- Fig. 3: a sectional view of the operating device of fig. 2 underneath a cover of an electric appliance and
- Fig. 4: a coffee machine as an electric appliance according to the invention with a display panel with the operating device of the invention.

### Detailed description of the exemplary embodiments

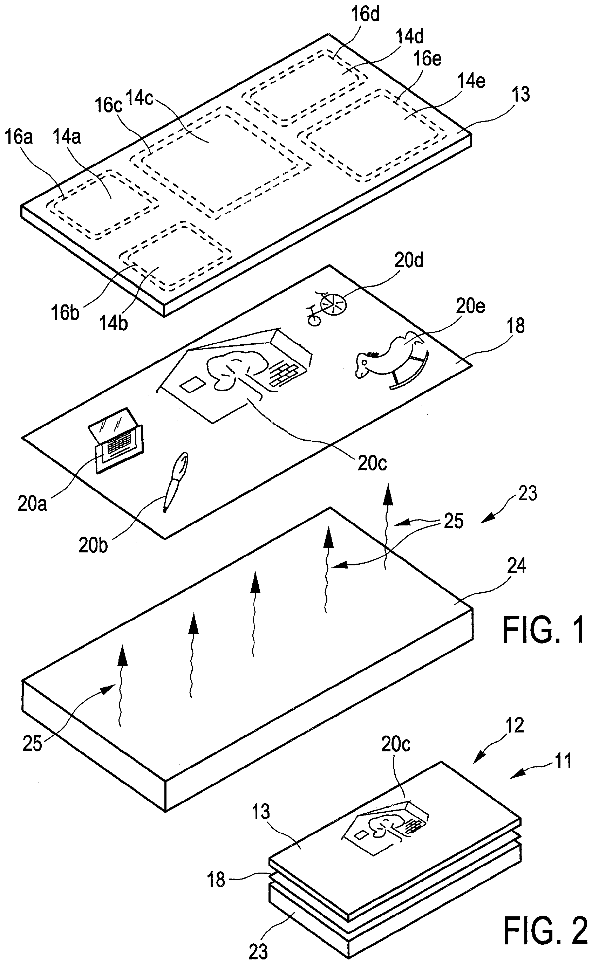

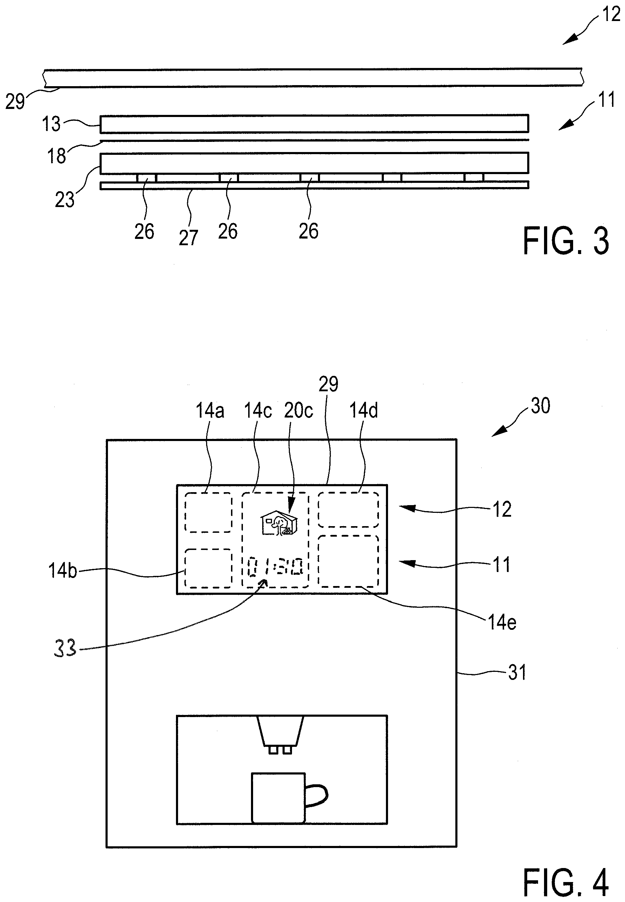

Fig. 1 shows an operating device 11 in an exploded view forming a display panel 12 according to fig. 3. An LCD display 13, in this case a so-called negative LCD, is provided in flat and rectangular form. The LCD display could also be curved or partly spherical. Furthermore, the LCD display 13 has several active areas 14a to 14e, which are provided in a distributed manner. The active areas 14a and 14b on the left are substantially square-like and have the same size. The middle active area 14c is a large one, and on the right side two differently shaped rectangular active areas 14d and 14e are provided. As the LCD display 13 is a negative LCD, it is black in a deactivated state or without an excitation voltage applied to it, respectively. The active areas 14a to 14e can be turned transparent by applying an excitation voltage to it, which renders the LCD display 13 transparent in this area.

On the top side of the LCD display 13, capacitive sensor elements 16a to 16e are provided, which are shown in broken lines. They are made up of a transparent material such as ITO and are connected to an electronic control, which preferably also controls the LCD display 13. The capacitive sensor elements 16a to 16e correspond in shape and location largely to the active areas 14a to 14e. They form touch switches as operating elements in the operating device 11 or an electric appliance equipped with the operating device, as is for example known from the prior art of EP 2111779 A.

Underneath the LCD display 13 a picture carrier 18 is provided. The picture carrier 18 is basically made up from a thin transparent material, preferably as a foil, the material being rather thin and somewhat flexible. On the basically transparent picture carrier 18, several pictures 20a to 20e are provided, for example printed to it in known manner. Their location corresponds to the one of the active areas 14a to 14e and their size or extension is somewhat smaller. This provides for a good covering of the pictures 20a to 20e by the active areas 14a to 14e as non-transparent cover in their deactivated state.

Underneath the picture carrier 18, a backlight device 23 is provided. This is preferably a conventional backlight device with light diffusing material 24 on its top side or forming its upper side. Light 25 being emitted from the backlight device 23 is largely uniformly distributed and provides a homogenous shine. This light 25 also provides for a characteristic and easily visible backlighting of the pictures 20a to 20e when the respective active area 14a to 14e above is activated and turned transparent. The light 25 can be regular white light, alternatively be colored light.

From fig. 2 it can be taken that the operating device 11 basically has the size of a conventional operating device with a backlit LCD display. In the state shown in fig. 2, the middle picture 20c is visible and also lit from behind. This means that the corresponding active area 14c has been activated and turned transparent. The other active areas are still deactivated and black, which covers and darkens the other pictures.

Fig. 3 shows the operating device 11 being mounted underneath or behind a cover 29, thus forming a display panel 12. Cover 29 is also transparent and can be glass or suitable resin. In the side view, it can be seen that the backlight device 23 is provided with several LED 26 underneath it, placed upon a printed cardboard 27. In another embodiment of the backlight device 23, the light sources or the LED 26, respectively, can be integrated into the backlight device 23.

Fig. 4 shows a coffee machine 30 as an electric appliance according to the invention. The coffee machine 30 has a housing 31 in conventional manner. On the upper part of the front side an operating device 11 as display panel 12 is provided behind a transparent cover 29, which is integrated into the housing 31 or forms a part of it. With the capacitive sensor elements integrated as touch switches, it is possible to operate the coffee machine 30 by touching one of the lit pictures or symbols of the operating device 11 with a finger, for example picture 20c, and thus activate the corresponding operating function.

Beneath the picture 20c an additional indication 33 of time for a timer function is provided with "01:30". Although this indication 33 rather seems to be in the form of a simple seven digit diplay, it can be displayed with the higher resolution of the LCD display 13 and in more or other detailed form.

## Claims

1. Operating device (11) for an electric appliance (30), wherein the operating device has a display panel (12) for a user to read off information, wherein the display panel (12) has an LCD display (13) covering substantially the area of the display panel and the LCD display has several separate active areas (14a-e), wherein behind the LCD display (13) a transparent flat material or foil is provided as a picture carrier (18) having several separate pictures (20a-e), icons or symbols on one of its surfaces, wherein behind the transparent picture carrier (18) a backlight device (23) is provided for shining through the picture carrier (18) and the LCD display (13), wherein the display panel (12) has operating elements (16a-e) for a user to operate the electric appliance (30) with the operating elements (16a-e), wherein the LCD display (13) is a negative LCD and the active areas (14a-e) are in an idle state black without excitation voltage and are in a display state transparent with an excitation voltage applied to them.

2. Operating device according to claim 1, wherein the active areas (14a-e) of the LCD display (13) are arranged according to a pattern, wherein said pattern is provided as a pattern field with several pattern areas, wherein said pattern areas have the average size of a regular pattern.

3. Operating device according to claim 2, wherein some active areas (14a-e) are made up of two to five such pattern areas.

4. Operating device according to one of the preceding claims, wherein the backlight device (23) provides for a uniform and homogenous lighting effect across its surface area.

5. Operating device according to claim 4, wherein the backlight device (23) is provided with LED (26) and light diffusing means (24) above the LED.

6. Operating device according to one of the preceding claims, wherein the picture carrier (18) covers only a part of the LCD display (13), wherein the rest of the LCD display is provided with LCD symbols of this LCD display being backlighted by the backlight device (23).

7. Operating device according to claim 6, wherein the picture carrier (18) covers a major part of the LCD display (13).

8. Operating device according to one of the preceding claims, wherein transparent capacitive sensor elements (16a-e) for touch switches as operating elements are provided on the display panel (12).

9. Operating device according to claim 8, wherein the transparent capacitive sensor elements (16a-e) are made from Indium Tin Oxide.

10. Operating device according to claim 8 or 9, wherein the transparent capacitive sensor elements (16a-e) are provided on the LCD display (13).

11. Operating device according to one of the claims 8 to 10, wherein the transparent capacitive sensor elements (16a-e) are provided on the upper side of the LCD display (13).

12. Electric appliance (30), **characterized by** an operating device (11) according to one of the preceding claims.

13. Electric appliance according to claim 12, wherein the electric appliance is a vending machine or a coffee machine (30).

## Patentansprüche

1. Bedieneinrichtung (11) für ein elektrisches Gerät (30), wobei die Bedieneinrichtung ein Anzeigefeld (12) aufweist, auf dem ein Benutzer Informationen ablesen kann, wobei das Anzeigefeld (12) eine Flüssigkristall(LCD)-Anzeige (13) aufweist, die im Wesentlichen den Bereich des Anzeigefelds abdeckt, und die LCD-Anzeige weist mehrere separate Aktivzonen (14a-e) auf, wobei hinter der LCD-Anzeige (13) ein transparentes Flachmaterial oder eine Folie als Bildträger (18) mit mehreren separaten Bildern (20a-e), Bildzeichen oder Symbolen auf einer seiner Flächen vorgesehen ist, wobei hinter dem transparenten Bildträger (18) eine Hintergrundbeleuchtungseinrichtung (23) vorgesehen ist, die durch den Bildträger (18) und die LCD-Anzeige (13) hindurchscheint, wobei das Anzeigefeld (12) Bedienelemente (16a-e) aufweist, mit denen ein Benutzer das elektrische Gerät (30) mit den Bedienelementen (16a-e) bedienen kann, wobei die LCD-Anzeige (13) als Negativ-LCD ausgebildet ist und die Aktivzonen (14a-e) in einem Ruhezustand, ohne Beaufschlagung von Erregerspannung, schwarz erscheinen und in einem Anzeigezustand, mit Beaufschlagung von Erregerspannung, transparent erscheinen.

2. Bedieneinrichtung nach Anspruch 1, wobei die Aktivzonen (14a-e) der LCD-Anzeige (13) in einem Muster angeordnet sind, wobei dieses Muster als Musterfeld mit verschiedenen Musterbereichen vorgesehen ist, wobei diese Musterbereiche die mittlere Größe eines regelmäßigen Musters aufweisen.

3. Bedieneinrichtung nach Anspruch 2, wobei einige Aktivzonen (14a-e) aus zwei bis fünf solcher Musterbereiche ausgebildet sind.

4. Bedieneinrichtung nach einem der vorhergehenden Ansprüche, wobei die Hintergrundbeleuchtungseinrichtung (23) einen gleichmäßigen und homogenen Beleuchtungseffekt über ihre Oberfläche bereitstellt.

5. Bedieneinrichtung nach Anspruch 4, wobei die Hintergrundbeleuchtungseinrichtung (23) mit Leuchtdioden (LED) (26) und Lichtdiffusionsmitteln (24) über den LED versehen ist.

6. Bedieneinrichtung nach einem der vorhergehenden Ansprüche, wobei der Bildträger (18) nur einen Teil der LCD-Anzeige (13) abdeckt, wobei der Rest der LCD-Anzeige mit LCD-Symbolen dieser LCD-Anzeige versehen ist, die von der Hintergrundbeleuchtungseinrichtung (23) von hinten beleuchtet werden.

7. Bedieneinrichtung nach Anspruch 6, wobei der Bildträger (18) einen Hauptteil der LCD-Anzeige (13) abdeckt.

8. Bedieneinrichtung nach einem der vorhergehenden Ansprüche, wobei transparente kapazitive Sensorelemente (16a-e) für Berührungsschalter als Bedienelemente auf dem Anzeigefeld (12) vorgesehen sind.

9. Bedieneinrichtung nach Anspruch 8, wobei die transparenten kapazitiven Sensorelemente (16a-e) aus Indiumzinnoxid gebildet sind.

10. Bedieneinrichtung nach Anspruch 8 oder 9, wobei die transparenten kapazitiven Sensorelemente (16a-e) auf der LCD-Anzeige (13) vorgesehen sind.

11. Bedieneinrichtung nach einem der Ansprüche 8 bis 10, wobei die transparenten kapazitiven Sensorelemente (16a-e) auf der Oberseite der LCD-Anzeige (13) vorgesehen sind.

12. Elektrisches Gerät (30), **gekennzeichnet durch** eine Bedieneinrichtung (11) nach einem der vorhergehenden Ansprüche.

13. Elektrisches Gerät nach Anspruch 12, wobei es sich bei dem elektrischen Gerät um einen Verkaufsautomaten oder eine Kaffeemaschine (30) handelt.

## Revendications

1. Dispositif de commande (11) pour un appareil électrique (30), le dispositif de commande ayant un panneau d'affichage (12) pour qu'un utilisateur y lise des informations, dans lequel le panneau d'affichage (12) a un écran LCD (13) couvrant sensiblement la surface du panneau d'affichage et l'écran LCD a plusieurs zones actives distinctes (14a-e), dans lequel, derrière l'écran LCD (13), un matériau plat transparent ou une feuille transparente est prévu comme support d'images (18) ayant plusieurs images distinctes (20a-e), des icônes ou des symboles sur une de ses surfaces, dans lequel, derrière le support d'images transparent (18), un dispositif de rétroéclairage (23) est prévu pour briller à travers le support d'images (18) et l'écran LCD (13), dans lequel le panneau d'affichage (12) a des éléments de commande (16a-e) pour qu'un utilisateur fasse fonctionner l'appareil électrique (30) avec les éléments de commande (16a-e), dans lequel l'écran LCD (13) est un LCD négatif et les zones actives (14a-e) sont noires dans un état au repos sans tension d'excitation et sont transparentes dans un état d'affichage avec une tension d'excitation qui leur est appliquée.

2. Dispositif de commande selon la revendication 1, dans lequel les zones actives (14a-e) de l'écran LCD (13) sont agencées selon un motif, ledit motif étant disposé comme une trame de motif avec plusieurs zones de motif, lesdites zones de motif ayant la taille moyenne d'un motif régulier.

3. Dispositif de commande selon la revendication 2, dans lequel certaines zones actives (14a-e) sont constituées de deux à cinq telles zones de motif.

4. Dispositif de commande selon une des revendications précédentes, dans lequel le dispositif de rétroéclairage (23) fournit un effet d'éclairage uniforme et homogène sur toute sa surface.

5. Dispositif de commande selon la revendication 4, dans lequel le dispositif de rétroéclairage (23) est doté d'une DEL (26) et de moyens de diffusion de la lumière (24) au-dessus de la DEL.

6. Dispositif de commande selon une des revendications précédentes, dans lequel le support d'images (18) couvre seulement une partie de l'écran LCD (13), le reste de l'écran LCD étant pourvu de symboles LCD de cet écran LCD rétroéclairés par le dispositif de rétroéclairage (23).

7. Dispositif de commande selon la revendication 6, dans lequel le support d'images (18) couvre une majeure partie de l'écran LCD (13).

8. Dispositif de commande selon une des revendications précédentes, dans lequel des éléments capteurs capacitifs transparents (16a-e) pour commutateurs tactiles sont prévus comme éléments de commande sur le panneau d'affichage (12).

9. Dispositif de commande selon la revendication 8, dans lequel les éléments capteurs capacitifs transparents (16a-e) sont constitués d'oxyde d'indium et d'étain.

10. Dispositif de commande selon la revendication 8 ou 9, dans lequel les éléments capteurs capacitifs transparents (16a-e) sont disposés sur l'écran LCD (13).

11. Dispositif de commande selon une des revendications 8 à 10, dans lequel les éléments capteurs capacitifs transparents (16a-e) sont disposés sur le côté supérieur de l'écran LCD (13).

12. Appareil électrique (30), **caractérisé par** un dispositif de commande (11) selon une des revendications précédentes.

13. Appareil électrique selon la revendication 12, l'appareil électrique étant un distributeur automatique ou une machine à café (30).
